# EUROPÄISCHE PATENTANMELDUNG

(11) **EP 2 144 073 A1**
(43) Veröffentlichungstag der Anmeldung: **13.01.2010**
(21) Anmeldenummer: 09161066.7
(22) Anmeldetag: 26.05.2009
(51) Int. Cl.: G01R 31/02, G01R 31/00

(54) **Prüfgerät sowie Verfahren zum Prüfen von elektrischen Leitungen eines elektrischen Verbrauchers eines Kraftfahrzeugs**

(30) Priorität: 09.07.2008 DE 102008040278
(71) Anmelder: ROBERT BOSCH GMBH, 70442 Stuttgart (DE)
(72) Erfinder: Schneider, Werner, 73262, Reichenbach A. D. Fils (DE)

(57) **Zusammenfassung**

Ein erfindungsgemäßes Prüfgerät (2) für die elektrischen Leitungen eines elektrischen Verbrauchers eines Kraftfahrzeugs umfasst einen Minusleitungs-Anschluss (4) zum Anschluss an die elektrische Minusleitung (36) des Verbrauchers anstelle des Verbrauchers; einen Minus-Referenzleitungs-Anschluss (10) zum Anschluss an den Stromerzeuger (46); einen Plusleitungs-Anschluss (8) zum Anschluss an die elektrische Plusleitung(38) des Verbrauchers anstelle des Verbrauchers; einen Plus-Referenzleitungs-Anschluss (10) zum Anschluss an den Stromerzeuger (46); wenigstens eine Einrichtung zum Belasten (22, 26) des Plusleitungs-Anschlusses (8) und des Minusleitungs-Anschlusses (4) mit einem vorbestimmten Stromfluss; eine Anzeige für einen minusseitigen Spannungsabfall (12); eine Anzeige für einen plusseitigen Spannungsabfall (14); eine erste Messschaltung zum Messen des minusseitigen Spannungsabfalls zwischen Minusleitungs-Anschluss (4) und Stromerzeuger (46); und eine zweite Messschaltung zum Messen des plusseitigen Spannungsabfalls zwischen Plusleitungs-Anschluss (8) und Stromerzeuger (46).

## Beschreibung

Die Erfindung betrifft ein Prüfgerät für die elektrischen Leitungen eines elektrischen Verbrauchers eines Kraftfahrzeugs sowie ein Verfahren zum Prüfen derselben.

In Kraftfahrzeugen gibt es eine Vielzahl von elektrischen Verbrauchern, wie Scheinwerfer, Heckscheibenheizungen, Sitzheizungen, Antriebsmotoren für verschiedenste Zwecke, bspw. elektrische Fensterheber, Magnetventile und elektrische Kraftstoff- und Vakuumpumpen. Diese Verbraucher besitzen im Normalbetrieb eine relativ große Stromaufnahme, die oft im Bereich zwischen 5 und 20 A liegt. In bestimmten Fällen wird die erforderliche Leistung der Verbraucher über eine pulsweiten-modulierte Rechteckspannung eingestellt. In anderen Fällen werden die Verbraucher nur sehr kurzzeitig angesteuert. Die relativ hohe Stromaufnahme bestimmter elektrischer Verbraucher stellt eine erhebliche Anforderung an das Bordnetz, insbesondere an die Leitungsverbindungen, Steckverbindungen, Leitungsstützpunkte in der Zentralelektrik und weitere beteiligte Komponenten. Häufig sind elektronische Steuergeräte zur Steuerung, zur Regelung oder zur Spannungsversorgung vorgesehen.

Im täglichen Betrieb von Kraftfahrzeugen ergibt sich oft das Problem, dass solche elektrische Verbraucher bedingt durch Spannungsabfälle in den elektrischen Leistungen, Steckverbindungen usw. nur noch eingeschränkt funktionieren oder ganz ausfallen. Neuere Entwicklungen gehen dahin, einzelne elektrische Verbraucher mit einer Eigendiagnosefunktion zu versehen, sodass ein fehlerhafter Betrieb oder ein Ausfall des elektrischen Verbrauchers angezeigt werden kann. Eine solche Fehlermeldung verrät jedoch nicht die tatsächliche Ursache des fehlerhaften Betriebs oder des Ausfalls. Diese Ursachen müssen mit aufwändigen Messmethoden ermittelt werden und überfordern das Werkstattpersonal häufig.

Es sind provisorische Messschaltungen mit einer H4-Scheinwerferlampe im Betrieb, die sehr aufwändig und nicht ungefährlich sind, weil hierbei sehr hohe Temperaturen am frei liegenden Glaskolben der H4-Scheinwerferlampe auftreten und hierdurch Schäden und Verletzungen verursacht werden können. Solche Messschaltungen liefern häufig nicht ausreichend aussagekräftige Messwerte, deren Anschluss ist darüber hinaus sehr zeitaufwändig und fehlerträchtig.

Es ist daher Aufgabe der vorliegenden Erfindung, ein Prüfgerät sowie ein Prüfverfahren anzugeben, mit denen die Ursachen für eine eingeschränkte Funktion oder für einen Ausfall eines elektrischen Verbrauchers eines Kraftfahrzeugs, aufgrund von Spannungsabfällen bzw. Übergangswiderständen, auf einfache Weise ermittelt werden können. Hierbei sollen insbesondere die elektrischen Leitungen eines elektrischen Verbrauchers eines Kraftfahrzeugs überprüft werden.

Diese Aufgabe wird durch den Gegenstand der unabhängigen Patentansprüche gelöst. Vorteilhafte Weiterbildungen ergeben sich aus den abhängigen Ansprüchen.

Das erfindungsgemäße Prüfgerät für die elektrischen Leitungen eines elektrischen Verbrauchers eines Kraftfahrzeugs gemäß dem unabhängigen Vorrichtungsanspruch und das erfindungsgemäße Prüfverfahren für die elektrischen Leitungen eines elektrischen Verbrauchers eines Kraftfahrzeugs gemäß dem unabhängigen Verfahrensanspruch erlauben eine schnelle, relativ einfache und zuverlässige Überprüfung der elektrischen Leitungen eines elektrischen Verbrauchers eines Kraftfahrzeugs. Eine zeitaufwändige Verkabelung entfällt, das erfindungsgemäße Prüfgerät wird einfach anstelle des elektrischen Verbrauchers angeschlossen, seine Referenzleitungen werden an den Stromerzeuger, insbesondere an die Batterie oder an den Generator bzw. die Lichtmaschine, angeschlossen, und der elektrische Verbraucher wird simuliert, indem dessen Plus- und Minusleitungen durch das Prüfgerät mit einem vorbestimmten Stromfluss belastet werden. Erfindungsgemäß wird dabei der plus- und minusseitige Spannungsabfall jeweils getrennt gemessen und angezeigt.

Durch das erfindungsgemäße Prüfgerät und Prüfverfahren werden die elektrischen Leitungen des Verbrauchers im Kraftfahrzeug mit einem definierten, vorbestimmten Stromfluss belastet, und alle Angaben bzgl. maximal zulässiger Spannungsabfälle in Reparatur- oder Fehlersuchanleitungen können einheitlich erfolgen.

Das erfindungsgemäße Prüfgerät und Prüfverfahren eignet sich prinzipiell für alle Systeme innerhalb des Kraftfahrzeugs, insbesondere für Systeme mit niederohmigen Verbrauchern. Es ist aber, nach entsprechender Änderung der Beschaltung, auch in anderen Bereichen einsetzbar.

Die Bedienung und die Adaption des erfindungsgemäßen Prüfgeräts am Fahrzeug ist einfach, die Anschlüsse des Prüfgeräts müssen mit der elektrischen Minus- und Plusleitung des Verbrauchers anstelle des Verbrauchers verbunden werden, und die Referenzleitungs-Anschlüsse müssen zu Beginn entweder direkt mit dem Stromerzeuger oder indirekt über Leitungsstützpunkte oder Komponenten in der Minus- oder Plusleitung des Verbrauchers mit den Stromerzeuger verbunden werden. Durch die erfindungsgemäßen Messschaltungen zum Messen und Anzeigen der minus- und plusseitigen Spannungsabfälle und die gleichzeitige Anzeige der Spannungsabfälle der Minus- und Plusleitung des Verbrauchers erhält man sofort sichere und eindeutige Messergebnisse, wodurch eine schnelle Fehlerfindung und Fehlereingrenzung erreicht wird.

Der vorbestimmte Belastungsstrom ist auf die in Fahrzeugsystemen derzeit üblichen Komponenten abzustimmen. Beispielhafte Belastungsstromflüsse liegen im Bereich zwischen 5 A, was etwa 60 W Leistung entspricht, oder 10 A, was etwa 120 W Leistung entspricht.

Das erfindungsgemäße Prüfgerät ist einfach aufgebaut und bedienbar sowie kostengünstig in der Herstellung und somit auch für kleine Werkstätten erschwinglich. Es sind keine zusätzlichen Messgeräte erforderlich. Weiterhin ist es möglich, die Messschaltung und das Messverfahren als Erweiterung in bereits bestehenden und in Werkstätten gebräuchlichen Testgeräten z.B. Motortester FSA XXX, KTS XXX zu integrieren.

Durch eine Verpolungsschutzschaltung und das Vorsehen einer ersten Einrichtung zum Belasten der Plusleitung und der Minusleitung mit einem vorbestimmten Belastungsstromfluss werden die Leitungen des Verbrauchers mit einer definierten Belastung geprüft. Wenn zusätzlich hierzu eine zweite Einrichtung zum Belasten der Plusleitung und der Minusleitung des Verbrauchers mit einem zweiten vorbestimmten, gegenüber dem ersten Stromfluss erhöhten Stromfluss vorgesehen ist, können die elektrischen Leitungen des Verbrauchers noch besser überprüft werden. Es erfolgt eine Simulation des Verbrauchers mit zwei definierten, voneinander verschiedenen Belastungsströmen.

Ebenso ist es möglich, die Belastungseinrichtung als Regler auszubilden, der einen variablen Stromfluss erzeugt.

Durch eine Verpolungsschutzschaltung und das Vorsehen wenigstens einer Anzeige, insbesondere einer LED, für die richtige Polarität der an den Referenzleitungs-Anschlüssen und an den Verbindungsleitungs-Anschlüssen angeschlossenen Leitungen können ein zuverlässiger Schutz vor falscher Verbindung bzw. ein Verpolungsschutz und somit eine sichere Anwendung des erfindungsgemäßen Prüfgeräts und Prüfverfahrens gewährleistet werden.

Wenn ein thermisch auslösender Schutzschalter vorgesehen ist, der bei zu langer Betätigung den Stromkreis in den Messschaltungen unterbricht, kann ein sicherer Überlastschutz und somit ein Schutz vor Beschädigung erreicht werden. Dieser Schutzschalter kann manuell oder automatisch wieder eingeschaltet werden. Alternativ dazu kann in den Messschaltungen ein Zeitglied vorgesehen sein, das eine vorbestimmte oder einstellbare Messdauer erlaubt und danach die Messschaltungen inaktiv schaltet, um sie vor einer Überlastung und einer daraus resultierenden Beschädigung zu schützen.

Die Erfindung betrifft auch die Verwendung eines Geräts der hier beschriebenen Art zum Prüfen der elektrischen Leitungen eines elektrischen Verbrauchers eines Kraftfahrzeugs.

Die Erfindung ist nachfolgend anhand von Ausführungsbeispielen mit Bezug auf die beiliegenden Figuren näher erläutert.
Figur 1 zeigt eine Frontansicht eines Prüfgeräts zum Prüfen der elektrischen Leitungen eines elektrischen Verbrauchers eines Kraftfahrzeugs gemäß einem Ausführungsbeispiel der Erfindung;
Figur 2 zeigt ein Blockschaltbild für das Prüfgerät aus Figur 1; und
Figur 3 zeigt eine schematische Darstellung des Ablaufs einer Stellmotor-Leitungsprüfung gemäß einem Ausführungsbeispiel der Erfindung.

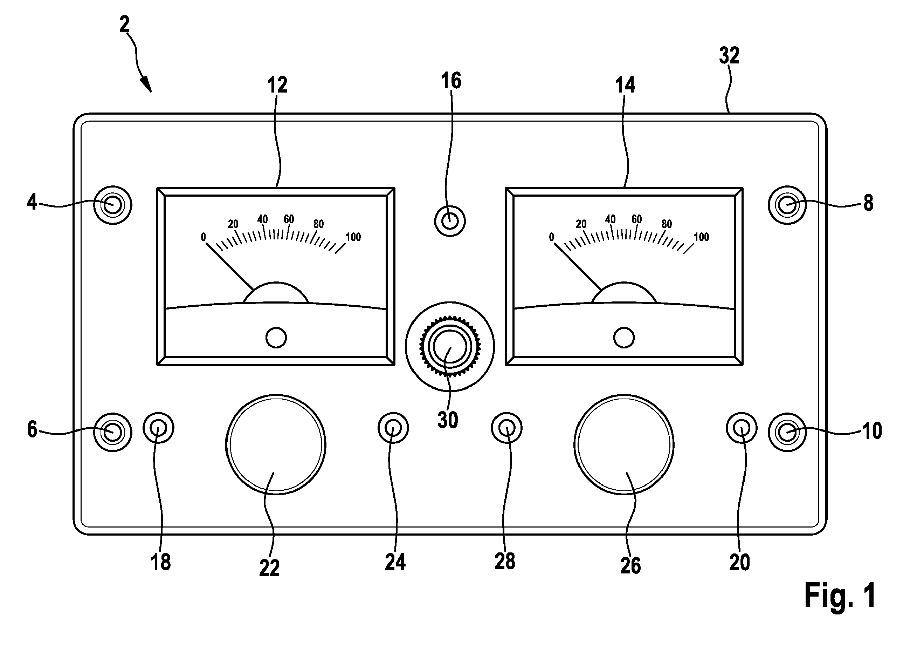

Figur 1 zeigt eine Frontansicht eines erfindungsgemäßen Prüfgeräts 2 zum Prüfen der elektrischen Leitungen eines elektrischen Verbrauchers eines Kraftfahrzeugs

Das Prüfgerät 2 umfasst ein im Wesentlichen quaderförmiges Gehäuse 32, auf dessen Frontseite die nachfolgend beschriebenen Elemente angeordnet sind.

Im oberen linken Eckbereich ist eine Minusleitungs-Anschlussbuchse 4 angeordnet, und im oberen rechten Eckbereich ist eine Plusleitungs-Anschlussbuchse 8 angeordnet. Im unteren linken Eckbereich ist eine Minus-Referenzleitungs-Anschlussbuchse 6 angeordnet, und im unteren rechten Eckbereich ist eine Plus-Referenzleitungs-Anschlussbuchse 10 angeordnet. Diese Buchsen 4, 6, 8 und 10 sind so ausgestaltet, dass gängige Prüfstecker darin eingesteckt werden können.

Zwischen der Minusleitungs-Anschlussbuchse 4 und der Plusleitungs-Anschlussbuchse 8 ist eine LED 16 für den Verpolungsschutz der Leitungs-Anschlussbuchsen angeordnet. Diese LED 16 leuchtet dann auf, wenn die Polarität der an den Buchsen 4 und 8 angeschlossenen Leitungen richtig ist.

Rechts neben der Minus-Referenzleitungs-Anschlussbuchse 6 ist eine LED 18 für deren Verpolungsschutz angeordnet, die aufleuchtet, wenn die an die Minus-Referenzleitungs-Anschlussbuchse 6 angeschlossene Minus-Referenzleitung die richtige Polarität hat. Ebenso ist links neben der Plus-Referenzleitungs-Anschlussbuchse 10 eine LED 20 für deren Verpolungsschutz vorgesehen, die dann aufleuchtet, wenn die an der Plus-Referenzleitungs-Anschlussbuchse 10 angeschlossene Plus-Referenzleitung die richtige Polarität hat.

Zwischen der Minusleitungs-Anschlussbuchse 4 und der LED 16 ist eine Anzeige für den minusseitigen Spannungsabfall 12 angeordnet. Diese Anzeige 12 für den minusseitigen Spannungsabfall ist als Analoganzeige ausgebildet und hat eine Skala von 0 bis 100. Ebenso ist zwischen der Plusleitungs-Anschlussbuchse 8 und der LED 16 eine Anzeige 14 für den plusseitigen Spannungsabfall angeordnet, die ebenfalls als Analoganzeige ausgebildet ist und eine Skala von 0 bis 100 aufweist. Die Anzeigen 12 und 14 können selbstverständlich auch als digitale Anzeigegeräte mit entsprechender Beschaltung verwendet werden. Alternativ dazu kann auch eine farbig ausgelegte Leuchtbalkenanzeige verwendet werden, die eine Gut-Schlecht-Anzeige erlaubt. Bei Integration in ein bestehendes Testgerät können die Messwertanzeigen auf dem vorhandenen Display bzw. Bildschirm erfolgen.

Unter der Anzeige 12 ist ein erster Belastungsschalter oder Belastungstaster 22 angeordnet, und rechts neben diesem ersten Belastungsschalter 22 befindet sich eine LED 24 für diesen ersten Belastungsschalter 22. Durch Drücken des ersten Belastungsschalters 22 werden die Minusleitungs-Anschlussbuchse 4, sowie die Plusleitungs-Anschlussbuchse 8 mit einem Belastungsstrom belastet, der im vorliegenden Ausführungsbeispiel etwa 5 A beträgt. Wenn der erste Belastungsschalter 22 gedrückt wird und demzufolge ein Belastungsstrom an den Anschlussbuchsen 4 und 8 anliegt, so leuchtet die zugehörige LED 24 auf.

Unterhalb der Anzeige für den plusseitigen Spannungsabfall 14 ist ein zweiter Belastungsschalter 26 mit einer links daneben angeordneten LED 28 für den zweiten Belastungsschalter 26 angeordnet. Auch durch das Drücken des zweiten Belastungsschalters 26 werden die Minusleitungs-Anschlussbuchse 4 und die Plusleitungs-Anschlussbuchse 8 mit einem Belastungsstrom belastet, der im vorliegenden Ausführungsbeispiel etwa 5 A beträgt.

Das Prüfgerät 2 verfügt darüber hinaus über die Funktionalität, dass bei einem gleichzeitigen Drücken der beiden Belastungsschalter 22 und 26 die Anschlussbuchsen 4 und 8 mit einem gegenüber dem normalen Belastungsstrom erhöhten zweiten Belastungsstrom belastet werden, der im vorliegenden Ausführungsbeispiel etwa 10 A beträgt. Zusätzlich zu den zwei Belastungsstufen, die durch die Betätigung der Belastungsschalter 22 und 26 erreicht werden können, können weitere Belastungsstufen vorgesehen werden. Ebenso ist es möglich, eine stufenlose Belastung zu realisieren, die bspw. durch einen Regler zum Belasten der Minusleitungs-Anschlussbuchse 4 und der Plusleitungs-Anschlussbuchse 8 mit einem variablen Stromfluss ausgestaltet sein kann.

Mittig zwischen den beiden Anzeigen 12 und 14 sowie unterhalb der LED 16 ist ein thermischer Sicherungsautomat 30 angeordnet. Dieser unterbricht bei zu langer Betätigung eines oder beider Belastungsschalter 24 und 28 die Messschaltungen, sodass der Belastungsstrom der Anschlussbuchsen 4 und 8 auf Null reduziert und das Prüfgerät 2 somit vor Beschädigung geschützt wird. Der thermische Sicherungsautomat 30 kann als Schutzschalter ausgebildet sein. Dieser kann so ausgebildet sein, dass er nach kurzer Wartezeit wieder eingeschaltet werden kann. Anstelle eines derartigen manuellen Schutzschalters ist auch die Verwendung eines automatischen, d. h., sich selbst wieder einschaltenden Schutzschalters möglich. Es ist auch möglich, die Einschaltzeit über ein Zeitglied zu begrenzen, um das Prüfgerät 2 vor zu hohem Stromfluss und daraus resultierender Beschädigung zu schützen.

Innerhalb des Gehäuses 32 ist eine erste Messschaltung angeordnet, die den minusseitigen Spannungsabfall zwischen der Minusleitungs-Anschlussbuchse 4 und der Minus-Referenzleitungs-Anschlussbuchse 6 misst und auf der Anzeige 12 für den minusseitigen Spannungsabfall anzeigt. In gleicher Weise ist eine zweite Messschaltung vorgesehen, die den plusseitigen Spannungsabfall zwischen der Plusleitungs-Anschlussbuchse 8 und der Plus-Referenzleitungs-Anschlussbuchse 10 misst und auf der Anzeige 14 für den plusseitigen Spannungsabfall 14 anzeigt.

Das Gehäuse 32 des Prüfgeräts 2 ist im vorliegenden Ausführungsbeispiel als werkstatttaugliches Kunststoffgehäuse ausgeführt. Alternativ dazu kann auch ein Metallgehäuse verwendet werden. Am Gehäuse, insbesondere an dessen Rückseite kann eine Aufhängevorrichtung, bspw. Aufhängeaussparungen angebracht sein, mithilfe derer das Prüfgerät 2 an einer geeigneten Stelle innerhalb des Fahrzeugs aufgehängt werden kann.

Das erfindungsgemäße Prüfgerät 2 ist für eine Spannung von 12 V ausgelegt, durch eine geänderte Beschaltung können beliebige andere Spannungen verarbeitet werden. Es sind auch eine 24-Volt-Variante oder weitere andere Spannungen möglich.

Für die erfindungsgemäße Prüfung der elektrischen Leitung eines elektrischen Verbrauchers eines Kraftfahrzeugs sind nur wenige Sekunden erforderlich. Ebenso kann das Prüfgerät 2 mit einem Speichermedium ausgestattet sein, um die Messwerte für den plus- und minusseitigen Spannungsabfall abzuspeichern.

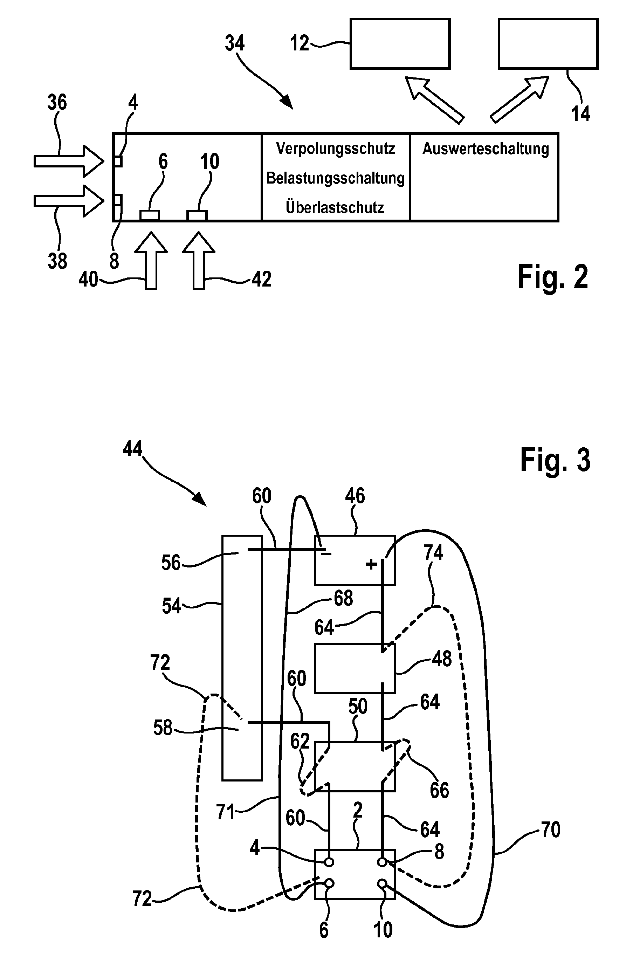

Figur 2 zeigt ein Blockschaltbild 34 für das erfindungsgemäße Prüfgerät 2 aus Figur 1.

Das Blockschaltbild 34 umfasst drei nebeneinander angeordnete Kästchen. In dem linken Kästchen sind die Minusleitungs-Anschlussbuchse 4, die Plusleitungs-Anschlussbuchse 8, die Minus-Referenzleitungs-Anschlussbuchse 6 und die Plus-Referenzleitungs-Anschlussbuchse 10 skizziert. Mittels Pfeilen sind eine Minusleitung 36 des Verbrauchers, eine Plusleitung 38 des Verbrauchers, eine Minus-Referenzleitung 40 zum Minuspol der Batterie oder des Generators, bspw. der Lichtmaschine, sowie eine Plus-Referenzleitung 42 zum Pluspol der Batterie oder des Generators dargestellt. Diese Leitungen werden im Betrieb des Prüfgeräts 2, wie in Figur 2 skizziert, an die Anschlussbuchsen 4, 8, 6 und 10 angeschlossen.

In dem mittleren Kästchen sind der Verpolungsschutz, die Belastungsschaltung, die in Figur 1 durch die Belastungsschalter 22 und 26 ausgeführt ist, und der Überlastschutz, der in Figur 1 durch den thermischen Sicherungsautomat 30 ausgeführt ist, dargestellt. Im Gerät ist eine Verpolungsschutzschaltung integriert. Über die LEDs wird nur die richtige Polarität angezeigt.

Im rechten Kästchen ist die Auswerteschaltung aufgeführt, welche die Funktionalität der ersten Messschaltung zum Messen des plusseitigen Spannungsabfalls zwischen Plusleitungs-Anschlussbuchse 8 und Plus-Referenzleitungs-Anschlussbuchse 10 und der zweiten Messschaltung zum Messen des minusseitigen Spannungsabfalls zwischen Minusleitungs-Anschlussbuchse 4 und Minus-Referenzleitungs-Anschlussbuchse 6 beinhaltet.

Die Anzeige 12 für den minusseitigen Spannungsabfall und die Anzeige 14 für den plusseitigen Spannungsabfall 14 sind in dem Blockschaltbild 34 als separate Kästchen dargestellt, die von der Auswerteschaltung angesteuert werden, was durch entsprechende Pfeile visualisiert ist.

Figur 3 zeigt eine schematische Darstellung 44 des Ablaufs einer Stellmotor-Leitungsprüfung gemäß einem Ausführungsbeispiel der Erfindung.

Das Blockschaltbild 44 umfasst dabei, von oben nach unten in Form von Rechtecken dargestellt, eine Batterie 46, eine Zentralelektrik 48, ein Steuergerät 50 und das erfindungsgemäße Prüfgerät 2, das anstelle des Stellmotors angeschlossen ist. Des Weiteren ist die Karosserie 54 des Kraftfahrzeugs als längliches Rechteck mit zwei Massepunkten 56 und 58 dargestellt.

Erfindungsgemäß sollen die Leitungsverbindungen zu einem Stellmotor geprüft werden. Im erfindungsgemäßen Ausführungsbeispiel nimmt der Stellmotor beim Verstellen einer Vorrichtung für ca. 1 s einen Spitzenstrom von ca. 15 A auf. Der Strom wird von dem Steuergerät 50 geschaltet und überwacht. Wird dieser Strom nicht erreicht, erfolgt ein Eintrag in den Fehlerspeicher des Steuergeräts.

Um eine dauerhafte Spannungsversorgung zu erreichen, kann in der Praxis das Systemsteuergerät abgezogen werden, und die Eingangs- und Ausgangsklemmen für Plus und Minus können am kabelbaumseitigen Steuergerätstecker mit ausreichend dimensionierten Kabelbrücken überbrückt werden.

Das Prüfgerät 2 wird durch entsprechend dimensionierte Adapterkabel anstelle des Verbrauchers, der durch den Stellmotor gebildet wird, angeschlossen.

Dieses Anschließen erfolgt über entsprechend dimensionierte Adapterleitung am Fahrzeugkabelstrang, Steckverbindungen oder dergleichen. Der Fahrzeugkabelstrang, Steckverbindungen usw. sollen geprüft werden.

Die Plusleitung 64 vom Verbraucher verläuft von dem Pluspol der Batterie 46 über die Zentralelektrik 48 und über die Überbrückung 66 am Steuergerät 50 zu der Plusleitungs-Anschlussbuchse 8 des Prüfgeräts 2. Die Minusleitung 60 verläuft vom Minuspol der Batterie 46 über den ersten Massepunkt 56, die Karosserie 54 und den zweiten Massepunkt 58 sowie über die Überbrückung 62 am Steuergerät 50 zu der Minusleitungs-Anschlussbuchse 4 des Prüfgeräts 52. Durch entsprechende Maßnahmen am Fahrzeug muss sichergestellt werden, dass eine Spannungsversorgung vorhanden ist. Wenn die Spannungsversorgung vorhanden ist und die Polarität der Leitungs-Anschlussbuchsen richtig ist, leuchtet die LED 16 auf.

Nur bei richtiger Polarität der an den Anschlussbuchsen 4 und 8 angeschlossenen Verbraucherleitungen werden die Referenzleitungs-Anschlüsse 6 und 10 danach mit der Batterie 46 verbunden. Dabei wird die Plus-Referenzleitungs-Anschlussbuchse 10 mittels einer Plus-Referenzleitung 70 direkt mit dem Pluspol der Batterie 46 verbunden. Die LED 20 für den Verpolungsschutz der Plus-Referenzleitung 70 leuchtet auf, wenn die Verbindung der Plus-Referenzleitung 70 hergestellt und die Polarität richtig ist. Die Minus-Referenzleitungs-Anschlussbuchse 6 wird mittels einer Minus-Referenzleitung 71 direkt mit dem Minuspol der Batterie 46 verbunden. Die LED 18 für den Verpolungsschutz der Minus-Referenzleitung 71 leuchtet auf, wenn die Verbindung der Minus-Referenzleitung 71 hergestellt und die Polarität richtig ist.

Durch Drücken des ersten Belastungsschalters 22 oder des zweiten Belastungsschalters 26 wird die gesamte Leitungsverbindung mit einem Belastungsstrom von etwa 5 A belastet. Wenn die Belastungsschalter 22 und 26 gleichzeitig gedrückt werden, erfolgt eine Belastung mit 10 A. Die Belastung wird durch entsprechendes Aufleuchten der LEDs 24 und 28 angezeigt. Während der Belastung werden der minusseitige Spannungsabfall auf der Anzeige 12 und gleichzeitig der plusseitigen Spannungsabfall auf der Anzeige 14 angezeigt. Die angezeigten Werte sind die Summe der Spannungsabfälle zwischen Batterieminuspol und Verbraucherminus bzw. zwischen dem Batteriepluspol und dem Verbraucherplus.

Durch Umklemmen der Referenzleitungen können die einzelnen Spannungsabfälle an Leitungsstützpunkten oder Komponenten ermittelt werden. Wenn bspw. ein überhöhter minusseitiger Spannungsabfall festgestellt wird, kann zum Suchen von Abschnitten in der Minusleitung mit überhöhtem Spannungsabfall die Minus-Referenzleitungs-Anschlussbuchse 6 an einem Leitungsstützpunkt der Minusleitung zwischen der Batterie 46 und der Minusleitungs-Anschlussbuchse 4 gesetzt werden. In dem Blockschaltbild 44 wird bspw. die Minus-Referenzleitung 72 so umgeklemmt, dass sie an dem zweiten Massepunkt 58 der Karosserie 56 angeschlossen ist. In gleicher Weise wird die Plus-Referenzleitung so umgeklemmt, dass die Plus-Referenzleitung 74 zu der Zentralelektrik 48 verläuft. Durch Umklemmen dieser Referenzleitungen für Plus und Minus an unterschiedlichen Messpunkten im Fahrzeug können die Spannungsabfälle schrittweise ermittelt und eingegrenzt werden.

## Patentansprüche

1. Prüfgerät (2) für die elektrischen Leitungen eines elektrischen Verbrauchers eines Kraftfahrzeugs, umfassend:
einen Minusleitungs-Anschluss (4) zum Anschluss an die elektrische Minusleitung (36) des Verbrauchers anstelle des Verbrauchers;
einen Minus-Referenzleitungs-Anschluss (10) zum Anschluss an den Stromerzeuger (46);
einen Plusleitungs-Anschluss (8) zum Anschluss an die elektrische Plusleitung (38) des Verbrauchers anstelle des Verbrauchers;
einen Plus-Referenzleitungs-Anschluss (10) zum Anschluss an den Stromerzeuger (46);
wenigstens eine Einrichtung zum Belasten (22, 26) des Plusleitungs-Anschlusses (8) und des Minusleitungs-Anschlusses (4) mit einem vorbestimmten Stromfluss;
eine Anzeige für einen minusseitigen Spannungsabfall (12);
eine Anzeige für einen plusseitigen Spannungsabfall (14);
eine erste Messschaltung zum Messen des minusseitigen Spannungsabfalls zwischen Minusleitungs-Anschluss (4) und Stromerzeuger (46); und
eine zweite Messschaltung zum Messen des plusseitigen Spannungsabfalls zwischen Plusleitungs-Anschluss (8) und Stromerzeuger (46).

2. Prüfgerät nach Anspruch 1, wobei eine zweite Einrichtung zum Belasten (26) der Plusleitung (38) und der Minusleitung (36) mit einem zweiten vorbestimmten, erhöhten Stromfluss vorgesehen ist.

3. Prüfgerät nach Anspruch 1 oder 2, wobei ein Regler zum Belasten der Plusleitung (38) und der Minusleitung (36) mit einem variablen Stromfluss vorgesehen ist.

4. Prüfgerät nach einem der Ansprüche 1 bis 3, wobei wenigstens eine Anzeige (16, 18, 20) für die richtige Polarität der an den Minus-Referenzleitungs-Anschluss (6), an den Plus-Referenzleitungs-Anschluss (10), an den Minusleitungs-Anschluss (4) und an den Plusleitungs-Anschluss (8) angeschlossenen Leitungen (36, 38, 40, 42) vorgesehen ist.

5. Prüfgerät nach einem der Ansprüche 1 bis 4, wobei ein thermisch auslösender Schutzschalter (30) vorgesehen ist, der bei zu langer Betätigung den Stromkreis in den Messschaltungen unterbricht.

6. Prüfgerät nach einem der Ansprüche 1 bis 4, wobei in den Messschaltungen ein Zeitglied vorgesehen ist, das eine vorbestimmte oder einstellbare Messdauer erlaubt.

7. Prüfgerät nach einem der Ansprüche 1 bis 6, wobei ein Speichermedium für die Speicherung der gemessenen Spannungsabfälle vorgesehen ist.

8. Verfahren zum Prüfen von elektrischen Leitungen eines elektrischen Verbrauchers eines Kraftfahrzeugs, umfassend:
Anschließen eines Minus-Referenzleitungs-Anschlusses (6) des Prüfgeräts (2) an den Minuspol des Stromerzeugers (46);
Anschließen eines Plus-Referenzleitungs-Anschlusses (10) eines Prüfgeräts (2) an den Pluspol des Stromerzeugers (46);
Anschließen eines Minusleitungs-Anschlusses (4) des Prüfgeräts (2) an die elektrische Minusleitung des Verbrauchers (60) anstelle des Verbrauchers; Anschließen eines Plusleitungs-Anschlusses (8) des Prüfgeräts (2) an die elektrische Plusleitung des Verbrauchers (64) anstelle des Verbrauchers; Belasten des Minusleitungs-Anschlusses (4) und des Plusleitungs-Anschlusses (8) mit einem vorbestimmten Stromfluss;
Messen und Anzeigen des minusseitigen Spannungsabfalls (12) zwischen Minusleitungs-Anschluss (4) und Stromerzeuger (46); und
Messen und Anzeigen des plusseitigen Spannungsabfalls (14) zwischen Plusleitungs-Anschluss (8) und Stromerzeuger (46).

9. Verfahren nach Anspruch 8, wobei, wenn ein überhöhter minusseitiger Spannungsabfall festgestellt wird, zum Suchen von Abschnitten in der Minusleitung mit überhöhtem Spannungsabfall der Minus-Referenzleitungs-Anschluss (6) an einen Leitungsstützpunkt der Minusleitung des Verbrauchers (60) zwischen dem Stromerzeuger (46) und dem Minusleitungs-Anschluss (4) versetzt wird, und die folgenden Verfahrensschritte wiederholt werden.

10. Verfahren nach Anspruch 8 oder 9, wobei, wenn ein überhöhter plusseitiger Spannungsabfall festgestellt wird, zum Suchen von Abschnitten in der Plusleitung mit überhöhtem Spannungsabfall der Plus-Referenzleitungs-Anschluss (10) an einen Leitungsstützpunkt der Plusleitung des Verbrauchers (64) zwischen dem Stromerzeuger (46) und dem Plusleitungs-Anschluss (8) versetzt wird, und die folgenden Verfahrensschritte wiederholt werden.
